# EUROPEAN PATENT APPLICATION

(11) **EP 4 629 026 A1**
(43) Date of publication of application: **08.10.2025**
(21) Application number: 25163596.7
(22) Date of filing: 13.03.2025
(51) Int. Cl.: G06F 1/26, G06F 1/30, H05K 7/14

(54) **POWER BRIDGING STRUCTURE FOR RACKS AND POWER BUS BAR BRIDGING DEVICE THEREOF**

(30) Priority: 15.03.2024 US 202463566063 P; 24.01.2025 CN 202510119106
(71) Applicant: DELTA ELECTRONICS, INC., Taoyuan City 320023 (TW)
(72) Inventor: CHANG, Ching-Tang, 320023 Taoyuan City (TW); HO, Chi-Shou, 320023 Taoyuan City (TW); CHIU, Chuang-Huan, 320023 Taoyuan City (TW)
(74) Representative: 2K Patentanwälte Blasberg Kewitz & Reichel

(57) **Abstract**

This disclosure is directed to a power bridging structure for racks and a power bus bar bridging device (50) thereof, the power bus bar bridging device (50) is used for bridging multiple power bus bars (20, 20a, 20b, 20c, 20d) in different racks (10, 10a, 10b, 10c, 10d). The power bus bar bridging device (50) has a bar housing (100), a plurality of power connectors (200, 200a) and a plurality of conductive bridges (300, 300a). The power connectors (200, 200a) are arranged in the bar housing (100). Each power connector (200, 200a) has a joint (210, 210a). Each joint (210, 210a) has a pair of claws (211, 211a) and each joint (210, 210a) is exposed from the bar housing (100). The conductive bridges (300, 300a) are arranged in the bar housing (100), and each conductive bridge (300, 300a) is connected to the power connectors (200, 200a). The power connectors (200, 200a) are respectively used for connecting to one of the rack power bus bars (20, 20a, 20b, 20c, 20d).

## Description

### Technical Field

This disclosure is directed to a power bridging structure, in particular to an expandable power bridging structure for racks and a power bus bar bridging device thereof.

### Description of Related Art

A related art server equipment has multiple racks, each rack may be provided with multiple servers. The related art racks are independent and connected to power supply inputs respectively. A data center has a limited space, and power may be dispatched between the racks, a connection between the racks via conductive wires leads to not only a difficulty of space arrangement of cabling but also damages caused by unstable power transmission via the conductive wires.

In view of this, in order to solve the above disadvantage, the inventor studied related technology and provided a reasonable and effective solution in this disclosure.

### SUMMARY OF THE INVENTION

This disclosure is directed to a power bridging structure for racks and a power bus bar bridging device thereof.

This disclosure is directed to a power bus bar bridging device used for bridging between plurality of power bus bars in different racks, the power bus bar bridging device has a bar housing, a plurality of power connectors and a plurality of conductive bridges. The power connectors are arranged on the bar housing. Each of the power connectors has a joint, each joint has a pair of claws, and the joints are exposed from the bar housing. The conductive bridges are disposed in the bar housing, each of the conductive bridges is connected to the power connectors. The power connector is used for connecting to one of the plurality of power bus bars.

This disclosure is directed to a power bridging structure for racks having a plurality of power bus bars and at least a power bus bar bridging device. A plurality of power bus bars are disposed on a plurality of rack, each of the power bus bars has a confluence side facing the rack and a bridging side facing away from the rack. The power bus bar bridging device has a bar housing, a plurality of power connectors and a plurality of conductive bridge, the power connectors are arranged on the bar housing, each of the power connectors has a joint, each joint has a pair of claws, and the joints are exposed from the bar housing, the conductive bridges are arranged in the bar housing and electrically connected to the power connectors respectively. The power connectors of the power bus bar bridging devices are respectively connected to the power bus bars are the bridging sides.

According to the power bridging structure for racks of this disclosure, it is easy to bridge multiple racks by a power bus bar bridging device. Power may be transmitted between the racks, and power may be supplied to all racks through only one of the racks. It is therefore easy to expand equipment.

### BRIEF DESCRIPTION OF THE DRAWINGS

The features of the disclosure believed to be novel are set forth with particularity in the appended claims. The disclosure itself, however, may be best understood by reference to the following detailed description of the disclosure, which describes a number of exemplary embodiments of the disclosure, taken in conjunction with the accompanying drawings, in which:
FIG. 1 is an exploded view showing a power bridging structure for racks applied to racks according to the first embodiment of this disclosure.
FIG. 2 is an exploded view showing the power bridging structure for racks and the racks according to the first embodiment of this disclosure.
FIG. 3 is a perspective view showing the power bridging structure for racks and a power bus bar thereof according to the first embodiment of this disclosure.
FIG. 4 is a perspective view showing the power bus bar of the power bridging structure for racks at an open status according to the first embodiment of this disclosure.
FIG. 5 is a perspective view showing the power bus bar bridging device according to the first embodiment of this disclosure.
FIG. 6 is a perspective view showing parts in the power bus bar bridging device according to the first embodiment of this disclosure.
FIG. 7 is a perspective view showing the power bridging structure for racks applied to racks according to the first embodiment of this disclosure.
FIG. 8 is a perspective view showing an electric connection of the power bridging structure for racks according to the first embodiment of this disclosure.
FIG. 9 is a cross-sectional view of the power bridging structure for racks according to the first embodiment of this disclosure.
FIG. 10 is a perspective view showing the power bridging structure for racks applied to racks according to the second embodiment of this disclosure.
FIG. 11 is a perspective view showing the power bridging structure for racks applied to racks according to the third embodiment of this disclosure.
FIG. 12 is a perspective view showing the power bus bar bridging device according to the third embodiment of this disclosure.
FIG. 13 is a perspective view showing the power bridging structure for racks applied to racks according to the fourth embodiment of this disclosure.

### DETAILED DESCRIPTION

The technical contents of this disclosure will become apparent with the detailed description of embodiments accompanied with the illustration of related drawings as follows. It is intended that the embodiments and drawings disclosed herein are to be considered illustrative rather than restrictive.

It should be understood that the orientations or positional relationships in this disclosure which are indicated by the terms such as "front side" , "rear side" , "left side" , "right side" , "front end" , "rear end" , "end" , "vertical" , "horizontal" , "vertical", "top" and "bottom" are based on the orientations or positional relationships as shown in the drawings. These are only used for describing this disclosure and simplifying the description rather than indicating or implying that the device or element have a specific orientation or be constructed and operated in a specific orientation, and it should not be considered as limitations of the scopes of this disclosure.

Detailed descriptions and technical contents of this disclosure is described in the flowing paragraph with reference to the drawings. However, the drawings are attached only for illustration and are not intended to limit this disclosure.

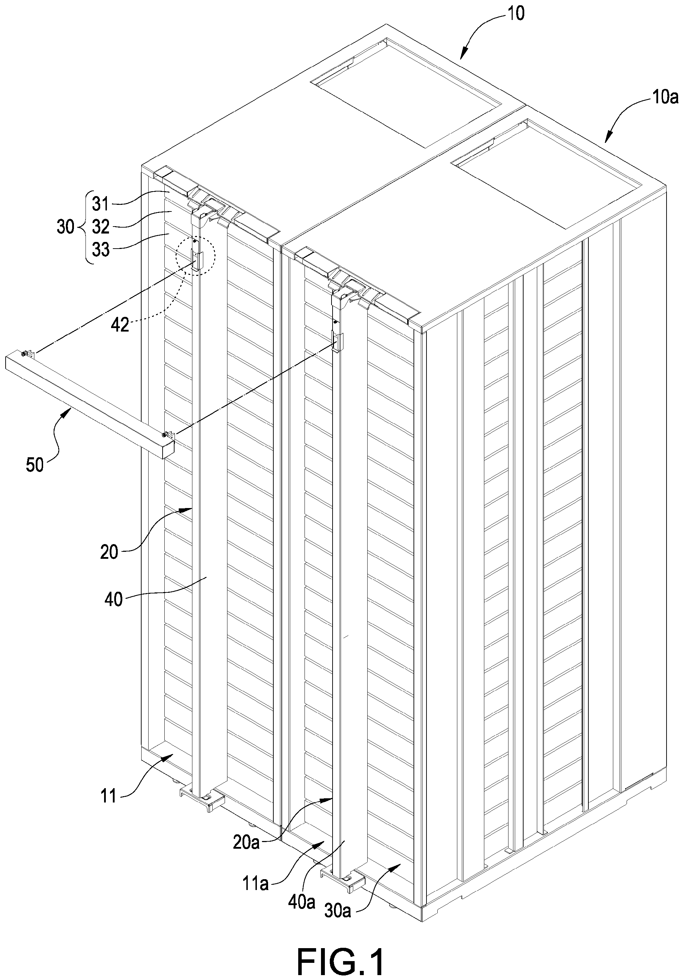

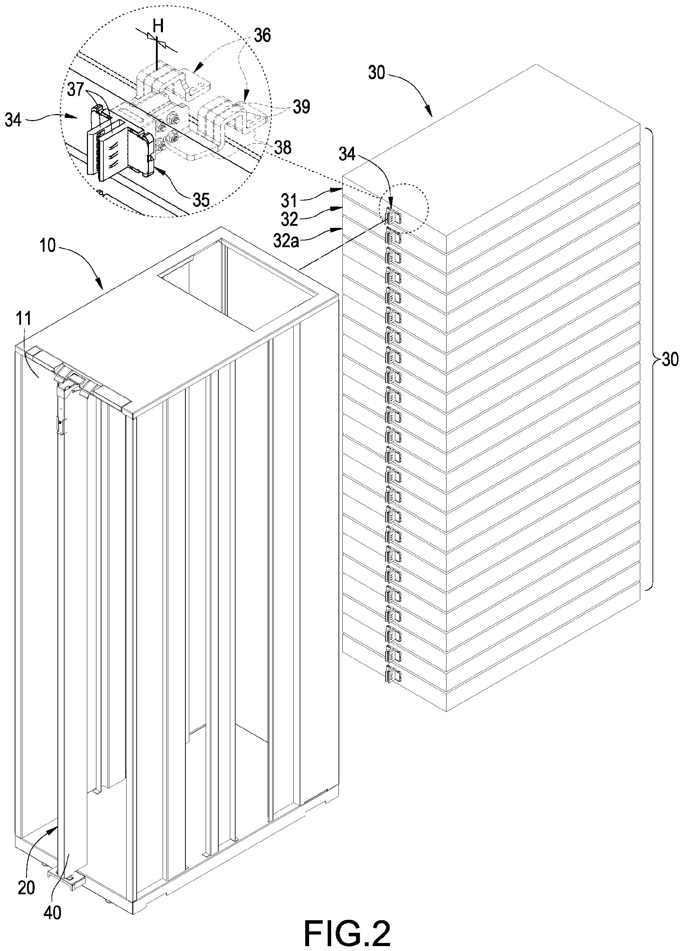

FIG. 1 is an exploded view showing a power bridging structure for racks applied to racks according to the first embodiment of this disclosure. Referring to FIG. 1, a power bridging structure for racks according to this embodiment is used for power bridging between two racks (10 and 10a). Two of the racks (10, 10a) as shown in FIG. 1 have structures identical or similar to each other. The identical or similar parts are illustrated according to the rack 10 in the following paragraphs. FIG. 2 is an exploded view showing the power bridging structure for racks and the racks according to the first embodiment of this disclosure.

According to this embodiment as shown in FIG. 2, the rack 10 has a cabinet of a rectangular shape, the cabinet is used for accommodating a plurality of electronic units 30, but the electronic units 30 are not limited to specific type(s). For example, a server unit 31, a power supply unit 32, and a backup battery unit 33 (BBU) may be included in the plurality electronic units 30 according to this disclosure. The server unit 31 may have components such as microprocessors, digital circuits, analog circuits, memory and storage devices. The power supply unit 32 may has at least one of the components of AC/DC conversion circuit, power factor correction circuit, DC/DC conversion circuit and battery. The power supply unit 32 may be coupled to AC power supply, DC power supply, other power supply units 32a and/or backup battery units 33 so as to supply power to the server unit 31. The rack 10 has a power bus bar 20 arranged at a power supplying side 11 of the cabinet. According to FIG. 1, the power bus bar 20 has two ends respectively fixed at an upper side and a lower side of the cabinet.

According to FIGS. 1 and 2, the power bridging structure for racks has a plurality of power bus bars (20, 20a) respectively arranged at the racks (10, 10a) and at least one power bus bar bridging device 50, the power bus bar bridging device 50 is used for coupling the power bus bar 20 on one of the racks 10 to the power bus bar 20a on another of the racks 10a, so as to transmit and dispatch power between two of the racks (10, 10a). According to this embodiment, the power bus bar 20 (or 20a) is defined with an axial direction disposed parallel to the power supplying side 11 of the cabinet and substantially perpendicular to a plan carrying the rack 10. The power bus bar bridging device 50 is connected to two of the power bus bars (20, 20a) mentioned above at sides away from the rack, and the axial direction of the power bus bar bridging device 50 is substantially parallel to the plane carrying the rack 10. In another embodiment, the power bus bar 20 (or 20a) may be connected with the rack 10, the plane carrying the rack 10a and the power bus bar bridging device 50 in another angles.

In some embodiments, the power supply unit 32 has a battery of other power storage devices. Accordingly, the power supply unit 32 may supply power to the server unit 31 and/or other power supply units 32, and the power supply unit 32 may be only used for power storage sometimes. For example, power is supplied to charge the battery only and the server unit 31, other power supply units and/or the backup battery unit 33 are not charged. The backup battery unit 33 may be configured for power supply or power storage.

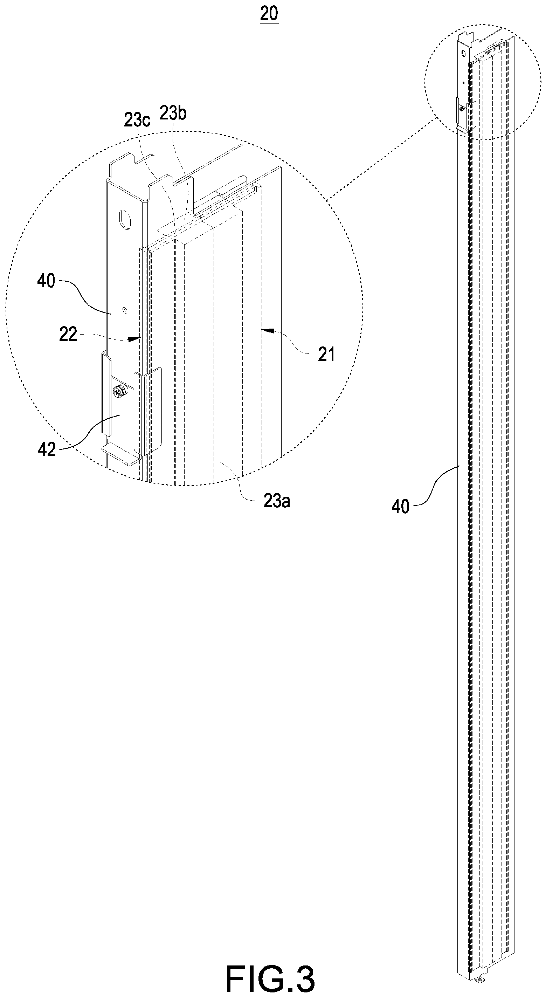

FIG. 3 is a perspective view showing the power bus bar 20 according to an embodiment. According to FIG. 2 and 3, the power bus bar 20 has a confluence side 21 facing to the rack 10 and a bridging side 22 disposed away from the rack 10, the electronic unit 30 is connected to the confluence side 21 of the power bus bar 20. According to this embodiment, the power bus bar 20 is disposed upright, a plurality of electronic units 30 are disposed in the rack 10. According to an example as shown in FIG. 2, a server unit 31 and two power supply units (32, 32a) are included in the plurality of electronic units 30, the electronic units 30 are disposed in a stack accommodated in the cabinet of the rack 10, and the electronic unit 30 has a power connector 34 disposed at a side thereof which is directed to the power bus bar 20 of connecting the power bus bar 20.

The power bus bar 20 as shown in FIG. 3 has a plurality of conductive bars (23a, 23b) and an insulative piece 23c clamped between the conductive bars (23a, 23b), each of the conductive bars (23a, 23b) has two side edges respectively disposed at the confluence side 21 and the bridging side 22. Specifically, each of the conductive bars (23a, 23b) is an elongated strip made of copper sheet or other material with adequate conduction, and the insulating piece 23c is an elongated strip made of plastic plate or other material with adequate insulation.

According to FIG. 2, each electronic unit 30 is provided with a power connector 34, the power connector 34 has a joint 35 and a pair of conductive arms 36, the joint 35 has a pair of claws 37, each of the conductive arms 36 has two ends respectively connected to the joint 35 and other parts of the electronic unit 30. Specifically, the conductive arm 36 has a bent elongated flat plate. Two of the conductive arms 36 are electrically connected to the claws 37 so as to electrically connected to the conductive bars (23a and 23b) of the power bus bar 20 respectively. Furthermore, each conductive arm 36 has a connecting segment 38, the connecting segment 38 has a plurality of elastic arms 39 arranged side by side, and the plurality of elastic arms 39 may be suitably defined with an interval H. Compared with a conductive arm 36 of single strip shape, the conductive arm 36 having the plurality of elastic arms 39 allows a larger elastic deformation in a direction along a connection line of the joint 35 and the electronic unit 30. In addition, a portion or entire of the conductive arm 36 may be disposed with a plurality of elastic arms 39 rather than the embodiment of single strip shape.

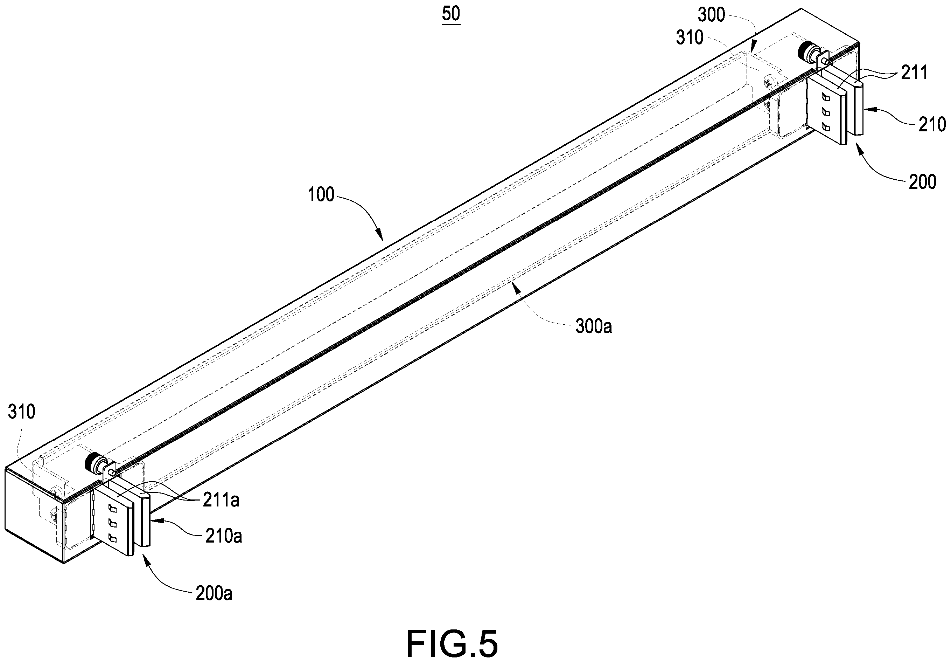

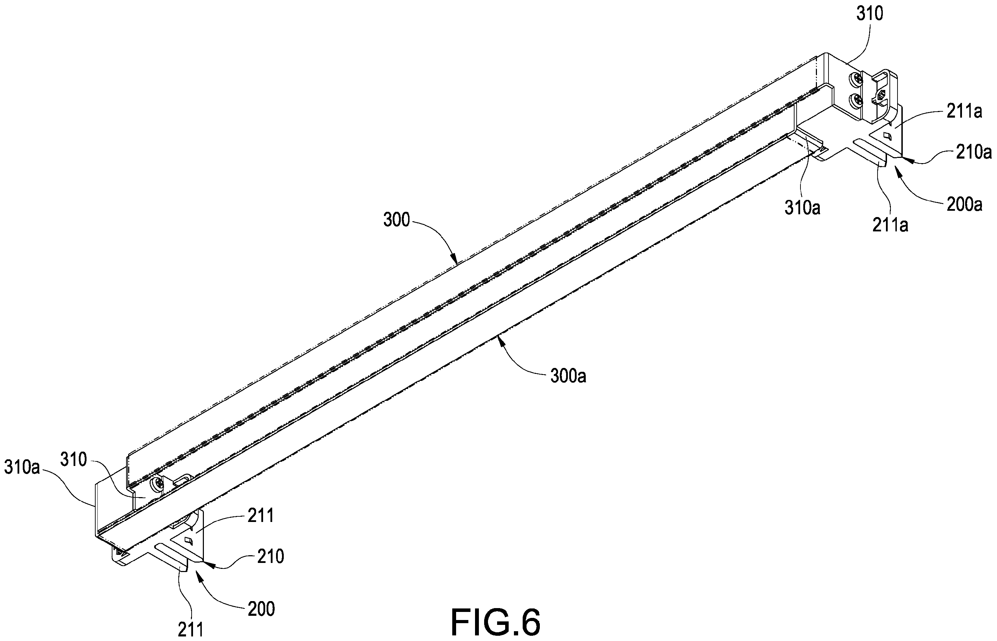

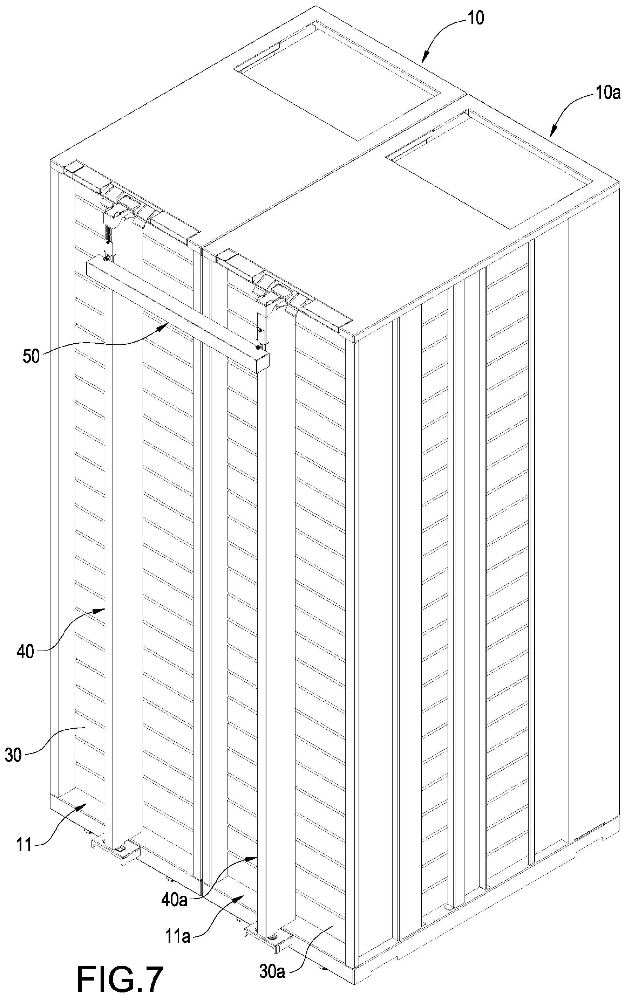

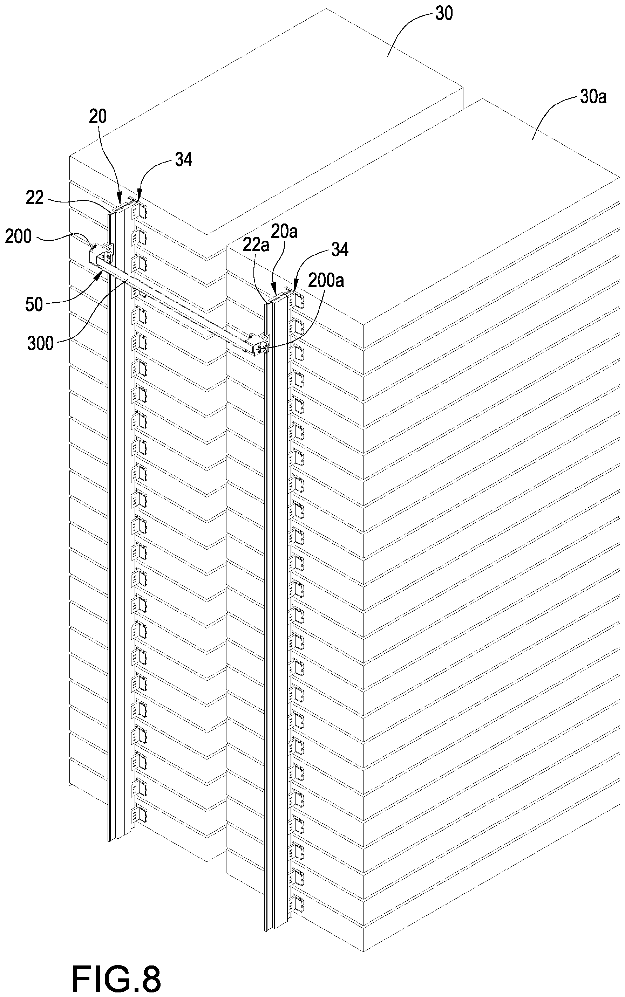

FIG. 5 is a perspective view showing the power bus bar bridging device 50 according to the first embodiment of this disclosure. FIG. 6 is a perspective view showing inner elements of the power bus bar bridging device 50 according to the first embodiment of this disclosure. FIG. 7 is a perspective view showing the power bridging structure for racks according to the first embodiment of this disclosure. FIG. 8 is a schematic view showing an electric connection of the power bridging structure for racks according to the first embodiment of this disclosure. According to FIGS. 5 to 8, the power bus bar bridging device 50 is used for electrically connecting a plurality of power bus bars (20, 20a) on a plurality of racks (10, 10a), the power bus bar bridging device 50 has a bar housing 100, a plurality of power connectors (200, 200a) and a plurality of conductive bridges (300, 300a). According to this embodiment, the power bus bar bridging device 50 has a bar housing 100, two power connectors (200, 200a) and two conductive bridges (300, 300a), two of the power connectors (200, 200a) are respectively arranged on the bar housing 100 at proper positions. For example, two of the power connectors (200, 200a) as shown in FIGS. 5 and 6 are respectively arranged at two ends of the bar housing 100. Each of the power connectors (200, 200a) has a joint (210, 210a), and two of the joints (210, 210a) are protruded from one side of the bar housing 100. Each of the joints (210, 210a) has a pair of claws (211, 211a). The conductive bridges (300, 300a) are arranged in the bar housing 100, each of the conductive bridges (300, 300a) has two ends respectively connected to the power connectors (200, 200a), and two of the conductive bridges (300, 300a) are electrically connected the claws (211, 211a) of the power connectors (200, 200a), respectively, so as to electrically connected to the conductive bars (23a and 23b) of the power bus bar 20. The bar housing 100 may be a square column, a cylindrical column or other column with a proper geometric shape and adequate rigidity which is used for protection and insulation of the conductive bridges (300, 300a) and other components accommodated therein. Each conductive bridge 300 (300a) has a pair of conductive arms 310 (310a) respectively disposed at two ends of the conductive bridge 300 (300a), each conductive arm 310 (310a) is a bent elongated flat plate, and the conductive arms (310, 310a) are respectively connected to the power connectors (200, 200a) correspondingly. The structure of the conductive arm 36 as shown in FIG. 2 may be applied to two of the conductive arms (310, 310a).

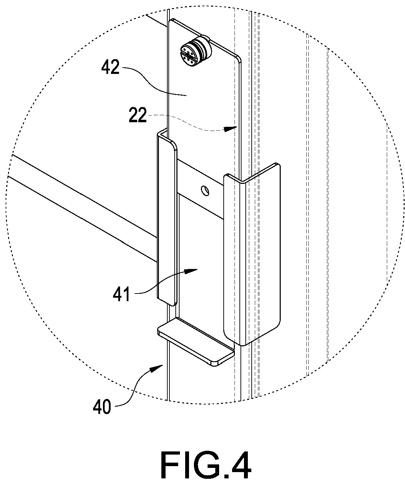

Referring to FIGS. 1 and 2, each of the power bus bars (20, 20a) of the racks (10, 10a) has a housing 40 (40a). According to one of the power bus bars 20 as shown in FIG. 3, the housing 40 covers the bridging side 22 of the power bus bar 20. Referring to FIG. 4, the housing 40 is provided with at least one through opening 41, and the housing 40 has a gate 42 corresponding to the through opening 41. The gate 42 may be disposed to expose or close the through opening 41 by moving up and down, rotating horizontally or rotating vertically so as to prevent unexpected touch by a user. For example, the gate 42 may be selectively moved up and down to close the through opening 41 as shown in FIG. 3 or expose the through opening 41 as shown in FIG. 4.

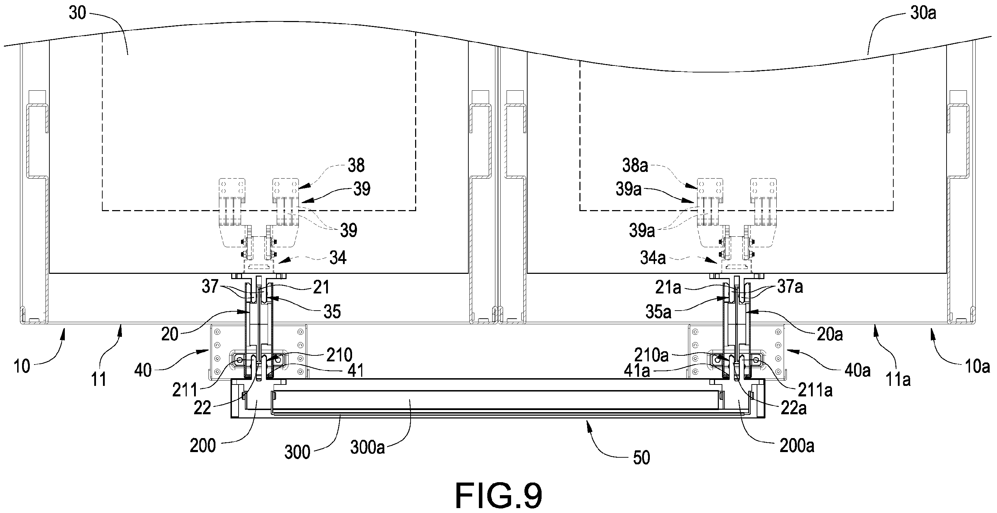

According to this embodiment as shown in FIG. 7, two of the power supplying sides (11, 11a) on the racks (10, 10a) are disposed side by side. FIG. 9 is a cross-sectional view of the power bridging structure for racks according to the first embodiment of this disclosure. For the purpose of illustration, the outer shell of each rack 10 (10a) and the housings (40, 40a) of the power bus bars (20, 20a) as shown in FIG. 9 are omitted in FIG. 8. The gate 42 may be selectively disposed as shown in FIG. 4 to open the through opening 41. When the gate 42 is opened as shown in the figure, the through opening 41 is aligned to a portion of the bridging side 22 of the power bus bar 20. Accordingly, the power connector 200 corresponding thereto as shown in FIG. 1 may be docked to the bridging side 22 of the power bus bar 20 through the through opening 41 as shown in FIGS. 7 to 9.

Referring to Figures 8 and 9, the power connectors (200, 200a) of the power bus bar bridging device 50 are respectively connected to the conductive bars (23a, 23b) of the power bus bar (20, 20a) at the bridging side (22, 22a) of the power bus bar (20, 20a). FIG. 9 is a cross-sectional view of the power bridging structure for racks according to the first embodiment of this disclosure. Referring to FIG. 9, one of the joints 210 of the power connectors 200 of the power bus bar bridging device 50 may be inserted through the through opening 41 for clamping the bridging side 22 of the power bus bar 20 with the claws 211 of the joint 210. Specifically, the pairs of the claws 211 (211a) respectively clamp the bridging side 22 (22a) of the power bus bar 20 (20a) correspondingly.

When the electronic unit 30 (30a) is connected to the corresponding power bus bar 20 (20a) via the power connector 34 (34a) as shown in FIGS. 8 and 9, the joint 35 (35a) clamps the confluence side 21 (21a) of the power bus bar 20 (20a) with the pair of claws 37 (37a), and the plurality of elastic arms 39 (39a) of the conductive arms 36 (36a) are connected to the joint 35 (35a) to provide a higher elastic deformation for assembly buffering between the joint 35 (35a) and the electronic unit 30 (30a), thereby allowing assembly tolerances when docking and preventing a stress concentration. Moreover, the conductive arms 36 (36a) may be maintained under an original structural strength.

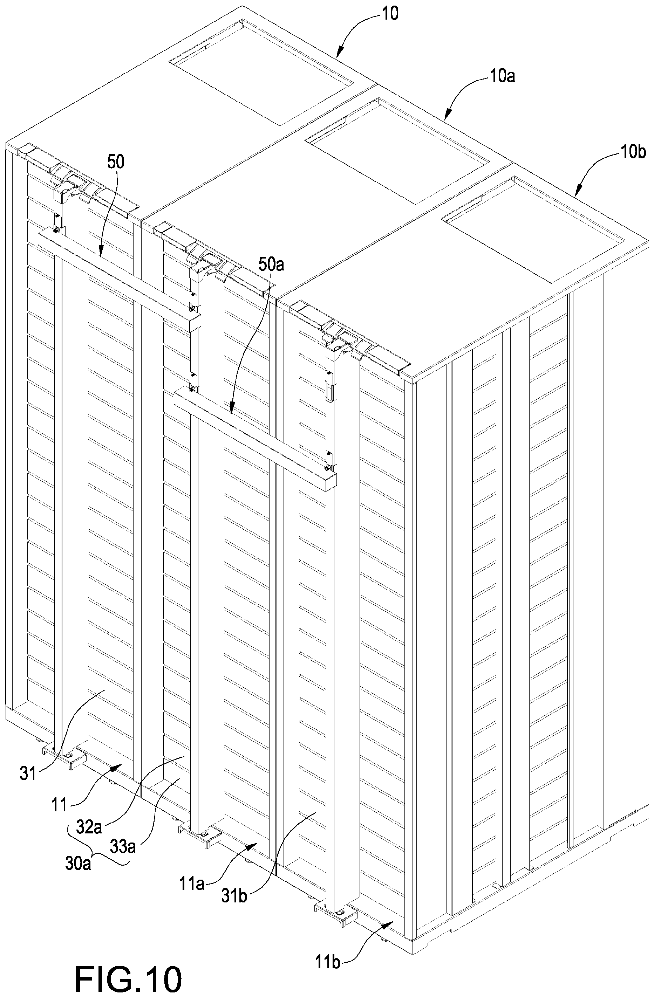

According to the second embodiment of this disclosure as shown FIG. 10, a power bridging structure for racks is used for power bridging of three racks (10, 10a, 10b). The power bridging structure for racks according to this embodiment has three power bus bars (20, 20a, 20b) respectively arranged on three of the racks (10, 10a, 10b) and two power bus bar bridging devices (50, 50a). Each of the racks (10, 10a, 10b) has a structure the same as the racks (10, 10a) described in the first embodiment, and each of the power bus bar bridging devices (50, 50a) has a structure the same as the power bus bar bridging device 50 described in the first embodiment. Therefore, the descriptions for the structures of the racks (10, 10a, 10b) and the power bus bar bridging devices (50, 50a) will not be repeated in this embodiment.

According to this embodiment, three racks (10, 10a, 10b) are arranged side by side in parallel, three power supplying sides (11, 11a, 11b) are arranged side by side in parallel and in a row. One of the power bus bar bridging devices 50 is disposed for bridging the rack 10 at one end of the row and the rack 10a at the center of the row; another of the power bus bar bridging device 50a is disposed for bridging the rack 10b at another end of the row and the rack 10a at the center of the row. Specifically, the power bus bar bridging devices (50, 50a) are respectively connected to the power bus bars (20, 20a, 20b) of the racks (10, 10a, 10b) via the power connectors (200, 200a) by docking as illustrated in the embodiments mentioned above. The arrangement of this embodiment allows power to be transmitted between three of the racks (10, 10a, 10b). Various combinations of electronic unit 30 may be arranged in the rack (10, 10a, 10b) respectively. For example, the electronic units 30a such as power supply unit 32a and backup battery unit 33a may be arranged in the rack 10a to provide power to other racks, and units that only consume power such as server units (31, 31b) may be arranged in the racks 10 and 10b. Power may be supplied to racks 10 and 10b from the rack 10a according the embodiment as shown in FIG. 10, so that the space configuration of the racks is more efficient.

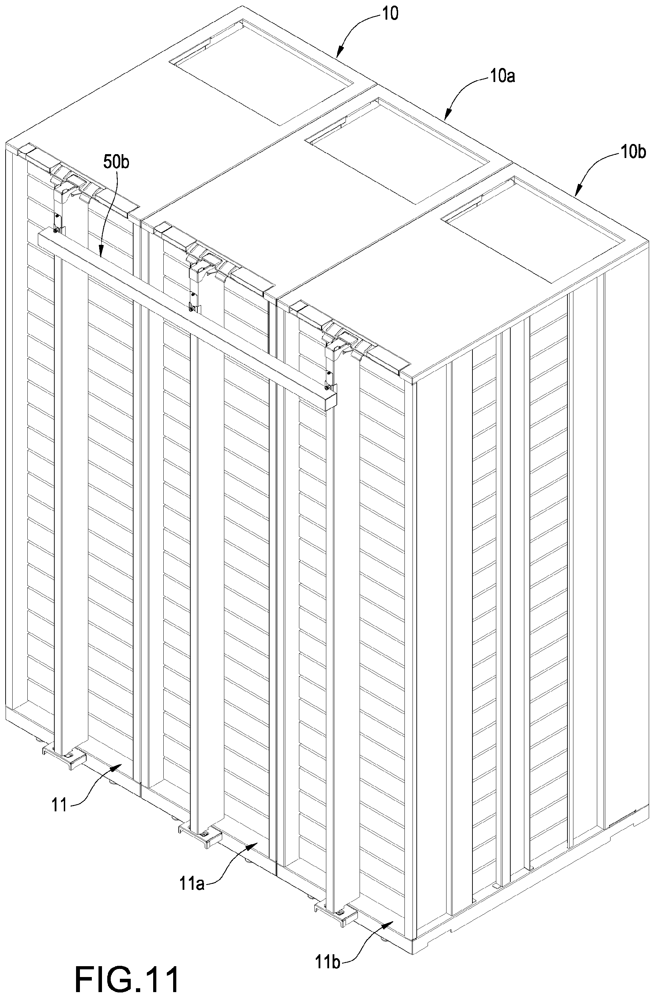

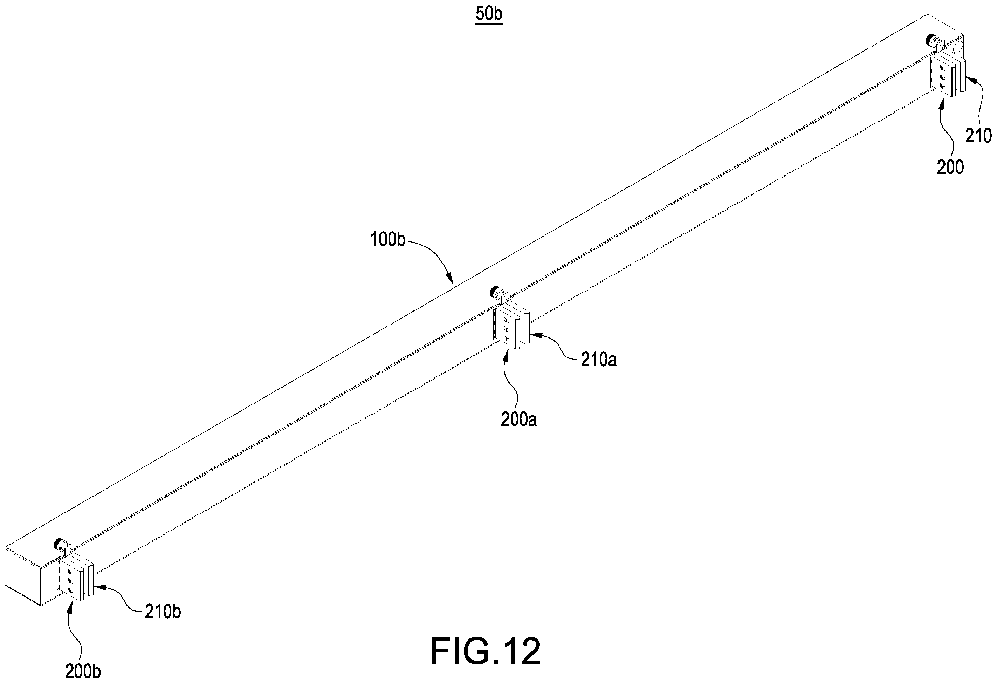

According to the third embodiment of this disclosure as shown in FIGS. 11 and 12, the power bridging structure for racks has three racks (10, 10a, 10b) and a power bus bar bridging device 50b. Each of the racks (10, 10a, 10b) has a structure the same as that of each of the racks (10, 10a, 10b) described in the embodiments mentioned above, so that the descriptions for the structure of the racks (10, 10a, 10b) will not be repeated in this embodiment.

According to this embodiment as shown in FIG. 12, a power bus bar bridging device 50b has a bar housing 100b and three power connectors (200, 200a, 200b). The structures of the bar housing 100 and the power connectors (200, 200a, 200b) are the same as the embodiments mentioned above. This embodiment is different from the embodiments mentioned above in the positional arrangement of the plurality of power connectors (200, 200a, 200b) on the bar housing 100b. In this embodiment, two of the three power connectors (200, 200b) are respectively disposed at two ends of the bar housing 100b, another of the three power connectors 200a is disposed at a middle section of the bar housing 100, and three joints (210, 210a, 210b) on the power connectors (200, 200a, 200b) are protruded from one side of the bar housing 100.

According to this embodiment as shown in FIGS 11. and 12, three racks (10, 10a, 10b) are arranged side by side in parallel and provided with three power supplying sides (11, 11a, 11b) arranged side by side in parallel. A power bus bar bridging device 50b is disposed across three of the racks (10, 10a, 10b), and the power connectors (200, 200a, 200b) of the power bus bar bridging device 50b are respectively connected to the racks (10, 10a, 10b) as the embodiments mentioned above. The arrangement of this embodiment allows power to be transmitted between three of the racks (10, 10a, 10b).

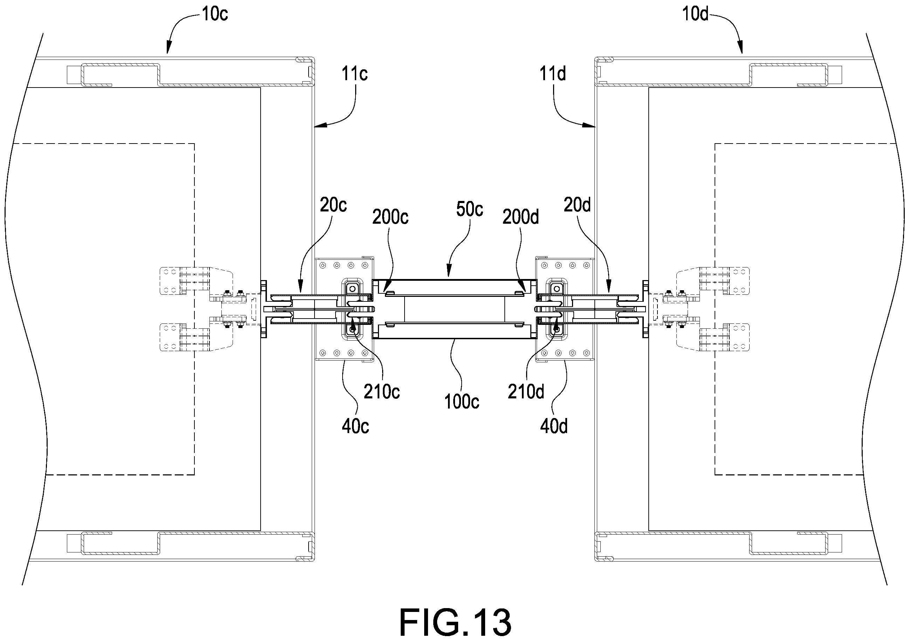

According to the fourth embodiment of this disclosure as shown in FIG. 13, a power bridging structure for racks is applied to two racks (10c, 10d). The power bridging structure for racks has a plurality of power bus bars (20c, 20d) respectively disposed on the racks (10c, 10d) and a power bus bar bridging device 50c. Each of the racks (10c, 10d) has a structure the same as that of each of the racks (10, 10a, 10b) described in the embodiments mentioned above, and the description for the structures of the racks (10c, 10d) will not be repeated in this embodiment. In this embodiment, two power supplying sides (11c, 11d) of two of the racks (10c, 10d) are facing to each other.

According to this embodiment, the power bus bar bridging device 50c has a bar housing 100c and two power connectors (200c, 200d). The bar housing 100c and the power connectors (200c, 200d) have structures substantially the same as that described in the embodiments mentioned above. This embodiment is different from the embodiments mentioned above at an arrangement of the plurality of power connectors (200c, 200d) disposed on the bar housing 100c. In this embodiment, two power connectors (200c, 200d) are respectively arranged at two ends of the bar housing 100c. Two joints (210c, 210d) respectively protrude out of the bar housing 100c in opposite directions along the longitudinal direction of the bar housing 100c. The power connectors (200c, 200d) of the power bus bar bridging device 50c are respectively connected to the power bus bars (20c, 20d) on the racks (10c, 10d). The power connectors (200c, 200d) are respectively connected to the power bus bars (20c, 20d) by clamping with joints (210c, 210d) thereof as described in the embodiments mentioned above. The arrangement mentioned above allows power to be transmitted between two of the racks (10c, 10d).

In another embodiment, the plurality of power connectors of the power bus bar bridging device may be respectively disposed on adjacent sides of the bar housing for power transmission between two racks facing to directions with an angle which is approximately 90 degrees.

According to the power bridging structure for racks of this disclosure, it is easy to bridge multiple racks by a power bus bar bridging device. Power may be transmitted between the racks, and power may be supplied to all racks through only one of the racks. It is therefore easy to expand equipment.

## Claims

1. A power bus bar bridging device (50) for bridging power bus bars (20, 20a, 20b, 20c, 20d) in different racks (10, 10a, 10b, 10c, 10d), comprising:
a bar housing (100);
a plurality of power connectors (200, 200a), arranged at the bar housing (100), wherein each of the power connectors (200, 200a) comprises a joint (210, 210a) protruded from the bar housing, and each of the joints (210, 210a) comprises a pair of claws (211, 211a); and
a plurality of conductive bridges (300, 300a), arranged in the columnar housing (100) and connected to the power connectors (200, 200a);
wherein the power connectors (200, 200a) are respectively used for connecting to one of the power bus bars (20, 20a, 20b, 20c, 20d) in different racks (10, 10a, 10b, 10c, 10d).

2. Thepower bus bar bridging device (50) according to claim 1, wherein the claws (211, 211a) of each of the power connectors (200, 200a) are connected to the conductive bridges (300, 300a) respectively.

3. Thepower bus bar bridging device (50) according to claim 1, wherein each of the conductive bridges (300, 300a) comprises a pair of conductive arms (310, 310a) disposed at two ends of the conductive bridge (300 or 300a), each of the conductive arms (310, 310a) comprises a bent elongated flat plate, and each of the conductive arms (310, 310a) is connected to the power connectors (200, 200a).

4. Thepower bus bar bridging device (50) according to claim 1, wherein two of the power connectors (200, 200a) are respectively disposed at two ends of the bar housing (100), and the joints (210, 210a) of the power connectors (200, 200a) are protruded from one side of the bar housing (100).

5. The power bus bar bridging device (50) according to claim 1, wherein two of the power connectors (200, 200a) are disposed at two end of the bar housing (100), another of the power connector (200, 200a) is disposed at a central segment of one end of the bar housing (100) and the joints (210, 210a) of the power connectors (200, 200a) are protruded from one side of the bar housing (100).

6. The power bus bar bridging device (50) according to claim 1, wherein two of the power connectors (200, 200a) are disposed at two ends of the bar housing (100), and the joints (210, 210a) are protruded from the bar housing (100) away from each other along a longitudinal direction of the bar housing (100).

7. A power bridging structure for racks, comprising:
a plurality of power bus bars (20, 20a, 20b, 20c, 20d) respectively disposed at a plurality of racks (10, 10a, 10b, 10c, 10d), each of the power bus bars (20, 20a, 20b, 20c, 20d) comprising a confluence side (21) facing the rack (10, 10a, 10b, 10c, 10d) and a bridging side (22, 22a) facing away from the rack (10, 10a, 10b, 10c, 10d); and
at least one power bus bar bridging device (50), comprising a bar housing (100), a plurality of power connectors (200, 200a) and a plurality of conductive bridges (300, 300a), the power connectors (200, 200a) arranged on the bar housing (100), each of the power connectors (200, 200a) comprising a joint (210, 210a), each of the joints (210, 210a) comprising a pair of claws (211, 211a), and each of the joint (210, 210a) protruded from the bar housing (100), the conductive bridges (300, 300a) arranged in the bar housing (100) and electrically connected to the power connectors (200, 200a) respectively,
wherein the power connectors (200, 200a) of the power bus bar bridging device (50) are correspondingly coupled to the bridging sides (22, 22a) on the power bus bars (20, 20a, 20b, 20c, 20d).

8. The power bridging structure for racks according to claim 7, wherein each of the power bus bar (20, 20a, 20b, 20c, 20d) comprises a housing (40), the housing (40) covers the bridging side (22, 22a) of the power bus bar (20, 20a, 20b, 20c, 20d), the housing (40) comprises at least a through opening (41), and the power connector (200, 200a) is correspondingly coupled to the bridging side (22, 22a) through the through opening (41).

9. The power bridging structure for racks according to claim 8, wherein the housing (40) comprises a gate (42) disposed corresponding to the through opening (41), and the through opening (41) is selectively covered by the gate (42).

10. The power bridging structure for racks according to claim 7, wherein in each of the racks (10, 10a, 10b, 10c, 10d), the power bus bar (20, 20a, 20b, 20c, 20d) on the rack (10, 10a, 10b, 10c, 10d) comprises a pair of conductive bars (23a, 23b) disposed in a stack, an insulative piece (23c) is clamped between the pair of conductive bars (23a, 23b), each of the conductive bar (23a, 23b) comprises two sides respectively disposed at the confluence side (21) and the bridging side (22, 22a).

11. The power bridging structure for racks according to claim 7, wherein in each of the power connectors (200, 200a), the claws (211, 211a) are electrically connected with the conductive bridges (300, 300a) respectively.

12. The power bridging structure for racks according to claim 7, wherein each of the conductive bridges (300, 300a) comprises a pair of conductive arms (310, 310a) respectively disposed at two ends of the conductive bridge (300, 300a), each of the conductive arms (310, 310a) is a zigzag elongated flat plate, and each of the conductive arms (310, 310a) are connected to the power connectors (200, 200a) respectively.

13. The power bridging structure for racks according to claim 11, wherein each of the racks (10, 10a, 10b) comprises a power supplying side (11, 11a, 11b), two of the power supplying sides (11, 11a, 11b) of the racks (10, 10a, 10b) are disposed side by side, two of the power connectors (200, 200a) are respectively disposed at two ends of the bar housing (100) and two of the joints (210, 210a) are protruded from a side of the bar housing (100).

14. The power bridging structure for racks according to claim 11, wherein each of the racks (10, 10a, 10b) comprises a power supplying side (11, 11a, 11b), two of the power supplying sides of the racks (10, 10a, 10b) are disposed side by side, two of the power connectors (200, 200b) are respectively disposed at two ends of the bar housing (100b), another of the power connectors (200a) is disposed at a central segment of the bar housing (100b), and the joints (210, 210a, 210b) of the power connectors (200, 200a, 200b) are protruded from a side of the bar housing (100b).

15. The power bridging structure for racks according to claim 11, wherein each of the racks (10c, 10d) comprises a power supplying side (11c, 11d), two of the power supplying sides (11c, 11d) of the racks (10c, 10d) are disposed opposite to each other, two of the power connectors (200c, 200d) are respectively disposed at two ends of the bar housing (100c) and two of the joints (210c, 210d) are protruded from the bar housing (100c) away from each other along a longitudinal direction of the bar housing (100c).
